# EUROPEAN PATENT APPLICATION

(11) **EP 3 421 646 A1**
(43) Date of publication of application: **02.01.2019**
(21) Application number: 17178834.2
(22) Date of filing: 29.06.2017
(51) Int. Cl.: C25D 11/08, B44C 3/02, C23C 14/00, C25D 11/10, C25D 11/12, C25D 11/16, C25D 11/18, C23C 16/00, C23C 28/00

(54) **COLOURING METHOD OF ALUMINIUM ALLOY MEMBER**

(71) Applicant: EMPA Eidgenössische Materialprüfungs- und Forschungsanstalt, 8600 Dübendorf (CH); COLORAL SA, 2000 Neuchâtel (CH)
(72) Inventor: Vicente Manzano, Maria Cristina, 3013 Bern (CH); Michler, Johann, 3626 Hünibach (CH); Philippe, Laetitia, 3012 Bern (CH); Storrer, Cédric, 2000 Neuchâtel (CH)
(74) Representative: Schneider Feldmann AG Patent- und Markenanwälte

(57) **Abstract**

The disclosed invention discloses a colouring method of a surface of an aluminium alloy member (0), belonging to the aluminium-magnesium-silicon family 6000 or 6xxx series, which allows creation of uniformly coloured aluminium alloy member surfaces, showing previously definable bright or matte colours. This is reached by, a polishing step of the aluminium alloy member surface, placing the polished aluminium alloy member into an 0.1M to 0.7M acid solution building an anode, before carrying out one single anodization step at a direct-current voltage of at least 30V, for an anodization time below 20 minutes, at temperatures between 0°C and 25°C, providing a porous aluminium alloy member surface layer comprising an unordered lateral distribution of pores, wherein the pores traverse the surface layer in the transverse direction, with a layer thickness of the porous aluminium alloy member surface layer between 100 nm up to 2 microns, followed by a concluding vapour deposition step, depositing a metal coating layer comprising Au, Cr, Pt, Ag, Al, Pt/Pd, C or Pd or mixtures thereof directly on the surface of the porous aluminium alloy member surface layer, resulting in a metal coating layer with a thickness between 1 to 50 nm.

## Description

### TECHNICAL FIELD

The present invention describes a colouring method of a surface of an aluminium alloy member, an aluminium alloy member belonging to the aluminium-magnesium-silicon family 6000 or 6xxx series with a coloured surface and a component part used as a part of a wristwatch, comprising an aluminium alloy member belonging to the aluminium-magnesium-silicon family 6000 or 6xxx series, coloured by the method.

### STATE OF THE ART

Several processes are known for colouring surfaces of aluminium alloy members, usually carried out using a variety of steps, comprising multiple anodization steps. In the anodization steps initially essentially colorless anodizing layers are treated as anodes in acidic solutions which contain one or more metal salts causing a coloring.

As disclosed in DE2116251 after the first anodization step, further colouring anodization steps are necessary, using certain electrolyte baths for reaching the desired colour are necessary. Also according to DE2116251 it was possible to narrow down the number of ingredients for the electrolyte baths, it is still a complex multi-step anodization process which uses a variety of electrolyte baths respectively ingredients for anodization to reach coloured surfaces.

Some other prior art document for colouring surfaces of aluminium alloy members, as US3849263, is directed towards the coloring of anodized aluminium by immersing said article in a bath containing a salt of a particular metal and passing an alternating current between the previously anodized article and a cathode as counterelectrode. These processes are extensive, time-consuming and expensive multi-step anodization processes, which cannot guarantee to reach matte colours of the aluminium alloy member, as desired.

CA1148110 describes an improved process for the production of colored protective coatings on articles of aluminium or aluminium alloys which again have been previously anodized in a very special way. Used metals or salts in the electrolyte bath are leading to colouring of the surface layer, while alternating current anodization steps are carried out. The disclosed anodizing techniques were carried out to reach an extremely dense and hard anodic coating and provide aluminium and aluminium alloy surfaces of very pleasing pure colors of exceptional uniformity. But still a multi-step anodization process had to be carried out, which is technically complex, connected to auxiliary working and the coloured surfaces could not deliver desired results.

Although there are some other methods known for treatment of aluminium surfaces by anodizing, for example as disclosed in US3524799, these methods do not reach a predictable reproducible matte or bright colouring of surfaces of aluminium alloy members.

Aluminium alloy members, comprising aluminium alloy of the wrought aluminium-magnesium-silicon family 6000 or 6xxx series are widely used in the watch industry to produce bezels, watch cases, back bodies, dials, movement parts and even straps. Alloys in this series contain silicon and magnesium in order to form magnesium silicide within the alloy. Extrusion products from the 6xxx series are the first choice for architectural and structural applications. The 6xxx series are versatile, heat treatable, highly formable, weldable and have moderately high strength coupled with excellent corrosion resistance.
The advantages of the 6XXX alloys are their good response to anodizing and their corrosion resistance properties, but so far the used colouring methods are technically complex and/or do not lead to desired colour results.

### DESCRIPTION OF THE INVENTION

The object of the present invention is to provide a colouring method for aluminium alloy members for creation of uniformly coloured aluminium alloy member surfaces, wherein the resulting colour is previously definable and can be bright or matte.

One object of the present invention is to provide a simplified method for uniformly colouring aluminium alloy members with bright colours.

Another object of the invention is to provide aluminium alloy members with defined bright or matte colour, in particular usable as component parts of a wristwatch, forming or being part in particular of a bezel, a watch case, a back body, a dial or a strap.

### BRIEF DESCRIPTION OF THE DRAWINGS

A preferred exemplary embodiment of the subject matter of the invention is described below in conjunction with the attached drawings.
- Figure 1a): shows a schematic sectional view of an aluminium alloy member after a preparation step, resulting in a polished surface, while
- Figure 1b): shows a schematic sectional view of the surface of the aluminium alloy member after single anodization step, presenting a porous aluminium alloy member surface layer with unordered lateral distribution of pores with special pore density and pore diameters, while
- Figure 1c): shows a schematic sectional view of the aluminium alloy member after vapour deposition step, resulting in a metal coating layer.
- Figure 2a): shows a schematic sectional view of an aluminium alloy member after a preparation step, resulting in a polished surface, while
- Figure 2b): shows a schematic sectional view of the surface of the aluminium alloy member after single anodization step, presenting a porous aluminium alloy member surface layer with unordered lateral distribution of pores with special average pore density and averaged pore diameters, while
- Figure 2c): shows a schematic sectional view of the prepared aluminium alloy member surface layer after at least partly removing step, while
- Figure 2d): shows a schematic sectional view of the surface of the aluminium alloy member after a second anodization step, before
- Figure 2e): shows a schematic sectional view of the aluminium alloy member after vapour deposition step, resulting in a metal coating layer.

### DESCRIPTION

Aluminium alloy members 0, in particular belonging to the aluminium-magnesium-silicon family 6000 or 6xxx series, were coloured by the here disclosed simplified process, reaching in particular bright colours. The used aluminium alloy members 0 of the 6000 or 6xxx series, are comprising at least 95% of aluminium and higher amounts of Silicon, Magnesium and Manganese with around 1%.

The in particular interesting aluminium alloy 6082, comprises:
Aluminium: 95.2 to 98.3%
Chromium: 0.25% max
Copper: 0.1% max
Iron: 0.5% max
Magnesium: 0.6 to 1.2%
Manganese: 0.4% to 1.0%
Silicon: 0.7 to 1.3%
Titanium: 0.1% max
Zinc: 0.2% max
Residuals: 0.15% max

A simplified colouring method, comprises a polishing step of the aluminium alloy member 0, one single anodizing step of the polished aluminium alloy member 0 and a subsequent coating step of the anodized surface of the aluminium alloy member 0, reaching colouring of the surface of the aluminium alloy member 0 with bright colours.

### Preparation step

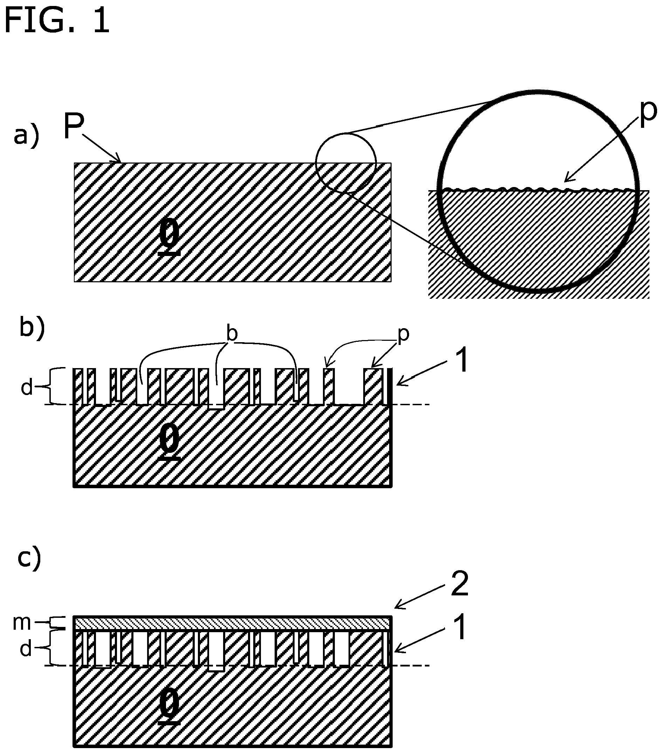

The raw aluminium alloy member 0 after a polishing step is shown in Fig. 1a. The polishing step is carried out, in order to reach a mirror-like polished surface P of the aluminium alloy member 0, as smooth as possible, with a maximum surface corrugation p below 2 nm.

The preparation by the polishing step of the surface of the alloy members 0 before the anodizing step, was done by a mechanical or electropolishing process before the anodization to reduce the roughness of the Al alloy member surface and convert the surface in a mirror.

The mechanical polishing was done using a polishing machine and polishing cloth along with alumina powders of 1, 0.5 and 0.03 microns.

The electropolishing can be done using a mixture of ethanol and perchloric acid (3:1) under a constant potential of 20 V for 2 minutes.

### single anodizing step of the aluminium alloy member

After the polishing step, the prepared polished aluminium alloy member 0 belonging to the aluminium-magnesium-silicon family 6000 or 6xxx series, is placed into an 0.1M to 0.7M oxalic acid solution, in particular 0.3M, forming an anode in an electrolyte bath. The cathode comprised platinum, in particular was formed as platinum containing mesh. The dimensions of the cathode should be greater-than-or-equal to the dimensions of the aluminium alloy member 0/anode. Beside oxalic acid solution, the electrolyte could comprise sulfuric acid respectively sulfuric acid + ethylene glycol or a mixture of oxalic acid and sulfuric acid.

The single anodization step is carried out at a direct-current voltage between 30-120 V, in particular of at least 40V, for an anodization time between 1 and 20 minutes, at temperatures between 0-25°C, in particular below 5°C in the electrolyte bath. The anodization step is carried out at the polished surface P of the prepared aluminium alloy member. The anodization step provides a porous aluminium alloy member surface layer 1 with a thickness d, comprising an unordered lateral distribution of pores b, wherein the pores traverse the surface layer in the transverse direction. As shown in the schematic drawing of Figure 1b, the porous oxide layer thickness d was reached between 100 nm up to 2 microns. The pore densities were 10⁸-10¹¹ pores/cm², with pore diameters between 12 nm-80 nm, determined by microscopy images of prepared surfaces.

### Vapour deposition step

Directly after the single anodization step a concluding vapour deposition step by sputtering or CVD is following, depositing a metal coating layer 2 with a thickness m onto the porous aluminium alloy member surface layer 1. The coating material can comprise Au, Cr, Pt, Ag, Al, Pt/Pd, C or Pd or mixtures thereof, in particular is gold. While the vapour deposition step, the pores b are not filled by the vapour deposition step/sputtering step. The metal coating layer 2 is a thin layer or thin film formed of nanoparticles onto or above the porous aluminium alloy member surface layer 1/anodized aluminium oxide layer.

Experiments showed best results with a metal coating layer 2 of Au with thickness m of 25 nm, deposited using a coating sputter. The sputter parameters used were 30 mA and 5.10⁻² mbar. The possible metal coating layer thickness m of Au varies between 1 and 50 nm, using range of current: 15-150 mA and the range of pressures: 8.10⁻³-1.10⁻¹ mbar.

### Example preparation of bright colours

With the disclosed method bright coloured aluminium alloy member surfaces can be reproducible created.

For example to obtain bright surface colouring of an aluminium alloy member:
Firstly, the samples were mechanically polished as described above.

Secondly, the anodization was performed as follows: 0.3 M oxalic acid aqueous solution was used as electrolyte, under a constant potential of 40 V and at 3 °C. The total volume of electrolyte was 1 l. The electrochemical cell consisted of a jacketed glass cylindrical reactor with a volume of 1 l. The refrigeration liquid was an ethylene glycol/water mixture (50/50) which in turns is cooled by a circulating cooling bath. The electrolyte was vigorously stirred (approx. 400 rpm) by means of a mechanical stirring set up, with a four bladed PTFE stirrer. To obtain yellow, green, blue or red, the anodization times were from 30 seconds to 15'.

Thirdly, the Au thin film of 25 nm was deposited using a coating sputter under 30 mA and 5.10⁻² mbar.

The observed colour of the prepared aluminium alloy member 0 surface is due to the interaction of light with pores nanostructures of the porous anodic aluminium oxide layer. The colour depends on the thickness and morphology of the metal coating layer 2 and on the morphology of the anodic aluminium oxide with porous oxide layer 1 (thickness, pore diameter, interpore distance, porosity).

### Method for matte colours

The colouring method for matte colouring, comprises a polishing step of the aluminium alloy member 0, a first anodizing step of the polished aluminium alloy member 0, a removing step, removing a first porous aluminium alloy member surface layer 1, a second anodizing step, producing a second porous aluminium alloy member surface layer 1' and a subsequent coating step of the two times anodized aluminium alloy member 0, reaching colouring of the surface of the aluminium alloy member 0 with matte colours.

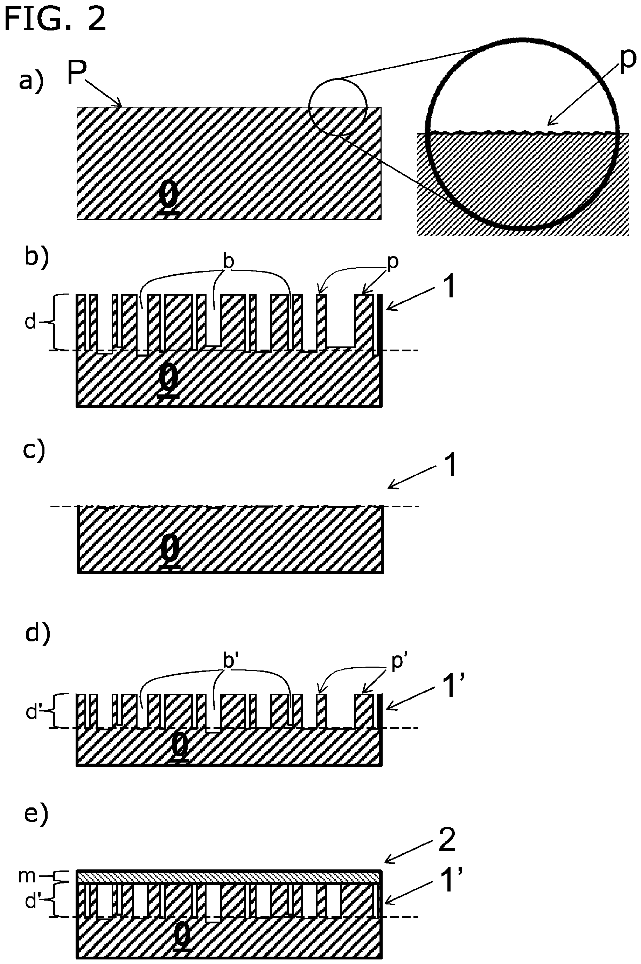

A modified colouring method is disclosed in the following. As stated above the aluminium alloy member 0 will be polished, resulting in a surface with mirror-like polished surface P of the aluminium alloy member 0, as smooth as possible, with a maximum surface corrugation p below 2nm as shown in figure 2a). The preparation is done as disclosed above.

After the polishing step, the prepared polished aluminium alloy member 0 belonging to the aluminium-magnesium-silicon family 6000 or 6xxx series, is placed into an 0.1M to 0.7M oxalic acid solution, in particular 0.3M, forming an anode in an electrolyte bath. The cathode comprised platinum, in particular was formed as platinum containing mesh. The dimensions of the cathode should be greater-than-or-equal to the dimensions of the aluminium alloy member 0/anode. Beside oxalic acid solution, the electrolyte could comprise sulfuric acid respectively sulfuric acid + ethylene glycol or a mixture of oxalic acid and sulfuric acid. The first anodization step is carried out at a direct-current voltage between 30-120 V, in particular of at least 40V, at temperatures between 0-25°C, in particular below 5°C in the electrolyte bath. This first anodization step is performed for an anodization time of a couple of hours, in particular of at least 20 hours, more particular 24 hours.

The first anodization step is carried out onto the polished surface P of the prepared aluminium alloy member 0. The first anodization step provides a porous aluminium alloy member surface layer 1 with a thickness d, comprising an unordered lateral distribution of pores b, wherein the pores traverse the surface layer in the transverse direction. As shown in the schematic drawing of Figure 2b, the porous oxide layer thickness d was reached in a range of a couple of microns. The average pore densities were 10⁸-10¹¹ pores/cm², with pore diameters between 12 nm-80 nm.

### Oxide layer removing step

After the first anodization step an oxide layer removing step is performed. Therefore the anodized aluminium alloy member 0 is removed from the electrolyte bath of the first anodization step and introduced in a chemical etching bath.

The chemical etching bath comprised adequate chemical etching solution for at least partly removing the first porous aluminium alloy member layer 1/anodic layer 1. We in particular used a mixture of phosphoric acid (7 wt.%) and chromic oxide (1.8 wt.%). As depicted in figure 2c) the anodic layer 1 after the first anodization step is completely removed, leaving a patterning on the surface of the remaining aluminium alloy member 0. The removing time differs between at least one hour to 24 hours. The chemical etching is typically carried out at room temperature for 20 to 24 hours.
For completely removing of the first porous aluminium alloy member 1, the chemical etching can be carried out at elevated temperatures of 45°C and more for at least one hour.

As chemical etching solutions, also a 5 wt. % of phosphoric acid solution and NaOH solution were successfully tried. The chemical etching time or removing time had to be adapted to these solutions.

### Second anodization step

After the chemical etching step, a second anodization step is carried out, in particular using the same parameters as in the first anodization step, except of the second anodization time. The anodization time of the second anodization step lay between 1 minute and 12 minutes.

For example for as a result later reaching blue matte colours at 5 minutes and for reaching red matte colours at about 10 minutes. As depicted in figure 2d) a second porous aluminum alloy member surface layer 1' with a thickness d' and a multiplicity of pores b' was reached after the second anodization step. Also the second porous aluminum alloy member surface layer 1' comprises an unordered lateral distribution of pores b', wherein the pores traverse the surface layer 1' in the transverse direction.

The porous oxide layer 1' thickness d' was reached between 100 nm up to 2 microns. The pore densities were 10⁸-10¹¹ pores/cm², with pore diameters between 12 nm-80 nm, determined by microscopy images of prepared surfaces.

### Vapour deposition step

After the second anodization step a concluding vapour deposition step by sputtering or CVD is following, depositing a metal coating layer 2 with a thickness m onto the second porous aluminium alloy member surface layer 1'. The coating material can comprise Au, Cr, Pt, Ag, Al, Pt/Pd, C or Pd or mixtures thereof, in particular is gold. While the vapour deposition step, the pores b' are not filled by the vapour deposition step/sputtering step. The metal coating layer 2 is a thin layer or thin film formed of nanoparticles onto or above the porous aluminium alloy member surface layer 1'/anodized aluminium oxide layer.

Experiments showed best results with a metal coating layer 2 of Au with thickness m of 25 nm, deposited using a coating sputter. The sputter parameters used were 30 mA and 5.10⁻² mbar. The possible metal coating layer thickness m of Au varies between 1 and 50 nm, using range of current: 15-150 mA and the range of pressures: 8.10⁻³-1.10⁻¹ mbar.

### Example preparation of matte colours

With the disclosed method matte coloured aluminium alloy member surfaces can be reproducible created.

Firstly, the samples were mechanically polished as described above.

Secondly, the anodization was performed as follows: 0.3 M oxalic acid aqueous solution was used as electrolyte, under a constant potential of 40 V and at 3 °C. The total volume of electrolyte was 1 l. The electrochemical cell consisted of a jacketed glass cylindrical reactor with a volume of 1 l. The refrigeration liquid was an ethylene glycol/water mixture (50/50) which in turns is cooled by a circulating cooling bath.
The electrolyte was vigorously stirred (approx. 350 rpm) by means of a mechanical stirring set up, with a four bladed PTFE stirrer.
The anodization time for the first anodization step was: 24 h.

Then, the first anodic layer 1 was removed by chemical etching in a mixture of phosphoric acid (7 wt.%) and chromic oxide (1.8 wt.%) at room temperature for 20 to 24 hours.

The second anodization was performed in the same conditions as the first one, but the second anodization times for the blue and red was 5 minutes and 10 minutes, respectively. The second anodic layer 1' was created.

Thirdly, the Au thin film of 25 nm was deposited using a coating sputter under 30 mA and 5.10⁻² mbar.

### LIST OF REFERENCE NUMERALS

- 0: Aluminium alloy member
P polished surface
p surface corrugation
- 1, 1': (first and second) porous aluminium alloy member surface layer (amorphous)
d, d' thickness
b, b' pores
- 2: Metal coating layer
m metal coating layer thickness

## Claims

1. Colouring method of a surface of an aluminium alloy member (0), belonging to the aluminium-magnesium-silicon family 6000 or 6xxx series
**characterized by:**
- a mechanical or electrochemical polishing step of the aluminium alloy member (0) surface, reaching a polished surface (P) with a maximum surface corrugation (p) below 2 nm,
- placing the polished aluminium alloy member (0) into an 0.1M to 0.7M acid solution building an anode, before
- carrying out one single anodization step at a direct-current voltage of at least 30V, in particular 40V,
for an anodization time below 20 minutes, in particular between 30 seconds and 15 minutes,
at temperatures between 0°C and 25°C, in particular below 5°C, providing a porous aluminium alloy member surface layer (1) comprising an unordered lateral distribution of pores (b), wherein the pores (b) traverse the surface layer (1) in the transverse direction, with a layer thickness (d) of the porous aluminium alloy member surface layer (1) between 100 nm up to 2 microns, a pore density between 10⁸-10¹¹ pores/cm² and pore diameters between 12 nm-80 nm, followed by
- a concluding vapour deposition step by sputtering or CVD,
depositing a metal coating layer (2) comprising Au, Cr, Pt, Ag, Al, Pt/Pd, C or Pd or mixtures thereof directly on the surface of the porous aluminium alloy member surface layer (1), resulting in a metal coating layer (2) with a thickness (m) between 1 to 50 nm, in particular with a thickness (m) between 20nm to 30nm.

2. Colouring method according to claim 1, wherein the anodization time of the first anodizing step is elongated to at least 20 hours, in particular to 24 hours and
an oxide layer removing step is introduced after the first anodization step, comprising chemical etching of the porous aluminium alloy member surface layer (1) to completely remove the porous aluminium alloy member surface layer (1) in a chemical etching time of at least one hour, leaving a patterning on the surface of the remaining aluminium alloy member (0), before a second anodization step with the same parameters as of the first anodizing step with anodization times in the minute range carried out,
followed by the concluding vapour deposition step.

3. Colouring method according to one of the preceding claims, wherein the polishing step was done mechanically, using a polishing machine and polishing cloth along with alumina powders of different grain sizes.

4. Colouring method according to one of the claims 1 or 2, wherein the polishing step was done with electropolishing, using a mixture of ethanol and perchloric acid (3:1) under a constant potential of 20 V for 2 minutes.

5. Colouring method according to one of the preceding claims, wherein the electrolyte bath comprises oxalic acid solution, sulfuric acid or a mixture of oxalic acid and sulfuric acid.

6. Colouring method according to claim 5, wherein the anodization was performed in an electrolyte bath with 0.3 M oxalic acid aqueous solution, under a constant potential of 40 V, at 3 °C.

7. Colouring method according to one of the preceding claims, wherein the electrolyte of the anodizing steps was stirred with more than 300 rpm by means of a mechanical stirring set up.

8. Colouring method according to one of the preceding claims, wherein the dimensions of the cathode are greater-than-or-equal to the dimensions of the aluminium alloy member (0) in the electrolyte bath.

9. Colouring method according to one of the preceding claims, wherein the sputtering step was carried out using a sputtering current between 15-150 mA applied in a vacuum with pressures between 8.10⁻³-1.10⁻¹ mbar, in particular using sputter currents of 30 mA and vacuum pressures of 5.10⁻² mbar.

10. Colouring method according to one of the claims 1 or 3 to 9, wherein application of the above mentioned steps and applied anodization times
of 1 minute led to red colours,
of 2 minutes led to blue colours,
of 7.5 minutes led to green colours,
of 12.5 minutes led to yellow colours,
while the other steps stayed unaltered.

11. Colouring method according to one of the claims 2 to 9 wherein application of the above mentioned steps and applied anodization times of the second anodization step
of 5 minutes led to matte blue colours,
of 10 minutes led to matte red blue colours, after concluding vapour deposition step.

12. Colouring method according to claim 2,
wherein the first anodic layer (1) is removed by chemical etching in a mixture of phosphoric acid, a mixture of phosphoric acid and chromic oxide or a mixture of NaOH at room temperature.

13. Aluminium alloy member belonging to the aluminium-magnesium-silicon family 6000 or 6xxx series with a bright coloured surface, comprising: a porous aluminium alloy member surface layer (1, 1') with a thickness (d, d') between 100 nm up to 2 microns, a pore density between 10⁸-10¹¹ pores/cm² and pore diameters between 12 nm-80 nm, wherein the porous aluminium alloy member surface layer (1, 1') shows an lateral unordered distribution of pores, which are traversing the porous aluminium alloy member surface layer (1, 1') in the transverse direction, wherein the surface of the porous aluminium alloy member surface layer (1, 1') is covered by a metal coating layer (2) with a thickness between 1 to 50nm, in particular 20nm to 30 nm, comprising Au, Cr, Pt, Ag, Al, Pt/Pd, C or Pd or mixtures thereof.

14. Component part used as a part of a wristwatch, comprising an aluminium alloy member (0) belonging to the aluminium-magnesium-silicon family 6000 or 6xxx series, with a surface bright coloured by the method according to claim 1 or a matte coloured surface coloured by the method according to claim 2, wherein the component part is forming or being part in particular of a bezel, a watch case, a back body, a dial or a strap.
